(19) Europäisches Patentamt / European Patent Office / Office européen des brevets

(11) **EP 4 211 549 B1**

(12) **EUROPEAN PATENT SPECIFICATION**

(45) Date of publication and mention
of the grant of the patent:
**26.11.2025 Bulletin 2025/48**

(21) Application number: **21765661.0**

(22) Date of filing: **24.08.2021**

(51) International Patent Classification (IPC):
**G06F 7/487** $^{(2006.01)}$ **G06F 7/544** $^{(2006.01)}$

(52) Cooperative Patent Classification (CPC):
**G06F 7/4876; G06F 7/5443; G06F 2207/3816**

(86) International application number:
**PCT/EP2021/073384**

(87) International publication number:
**WO 2022/053305 (17.03.2022 Gazette 2022/11)**

(54) **FLOATING POINT COMPUTATION FOR HYBRID FORMATS**

GLEITKOMMABERECHNUNG FÜR HYBRIDE FORMATE

CALCUL DE VIRGULE FLOTTANTE POUR FORMATS HYBRIDES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.09.2020 US 202016948195**

(43) Date of publication of application:
**19.07.2023 Bulletin 2023/29**

(73) Proprietor: **International Business Machines
Corporation
Armonk, New York 10504 (US)**

(72) Inventors:
• **AGRAWAL, Ankur**
**Yorktown Heights, New York 10598-0218 (US)**
• **FLEISCHER, Bruce**
**Yorktown Heights, New York 10598-0218 (US)**

(74) Representative: **IBM United Kingdom Limited
Intellectual Property Law
Hursley Park
Winchester, Hampshire SO21 2JN (GB)**

(56) References cited:
US-A- 5 268 855          US-A1- 2020 026 494
US-A1- 2020 249 910

**Description**

BACKGROUND

The present invention relates in general to computing systems, and more particularly to, various embodiments for floating point computation for hybrid formats in a computing system. United States Patent Application Publication number US 2020/0249910 A1, Wang, N. et al ("Hybrid Floating Point Representation for Deep Learning Acceleration", 6 August 2020) discloses a method including configuring a specialized circuit for floating point computations using numbers represented by a hybrid format, wherein the hybrid format includes a first format and a second format. In the embodiment, the method includes operating the further configured specialized circuit to store an approximation of a numeric value in the first format during a forward pass for training a deep learning network. In the embodiment, the method includes operating the further configured specialized circuit to store an approximation of a second numeric value in the second format during a backward pass for training the deep learning network. United States Patent number US 5268855, Mason, R.W. et al ("Common Format for Encoding Both Single and Double Precision Floating Point Numbers", 7 December 1993) discloses a technique for encoding multiple floating point formats into a double precision floating point number by padding single word floating point numbers with zeros to form a 64-bit double word in a way that allows a single precision arithmetic logic unit to be built on top of a double precision arithmetic logic unit.

SUMMARY

According to the present invention there are provided a method, a system, and a computer program product. According to an embodiment of the present invention, a method for floating point computation for hybrid formats (e.g., performing hybrid precision floating point format computation via a simplified superset floating point unit) in a computing system is provided. One or more inputs, represented as a plurality of floating point number formats, may be converted into a superset floating point format prior to computation by one or more simplified superset floating point units (ssFPUs). A compute operation may be performed on the one or more inputs represented as the superset floating point format using the one or more ssFPUs. In one aspect, the superset floating point format may be a 9-bit floating point format ("FP9") comprising a sign bit, exponent bits (e), and mantissa bits (m). The ssFPU's may be a 9-bit floating point unit that only operates on the superset floating point format (e.g., the 9-bit floating point format ("FP9")).

In an additional embodiment, a plurality of inputs, represented as very low precision ("VLP") floating point formats, may be converted into a superset floating point format. A compute operation may be performed on the plurality of inputs represented as the superset floating point format using an array of ssFPUs.

In an additional embodiment, input operands, represented as very low precision ("VLP") floating point formats, may be converted into a superset floating point format to prevent rounding errors prior to performing a compute operation in an array of simplified superset floating point units (ssFPUs). A compute operation may be performed on the inputs represented as the superset floating point format using the array of the ssFPUs.

An embodiment includes a computer usable program product. The computer usable program product includes a computer-readable storage device, and program instructions stored on the storage device.

An embodiment includes a computer system. The computer system includes a processor, a computer-readable memory, and a computer-readable storage device, and program instructions stored on the storage device for execution by the processor via the memory. Thus, in addition to the foregoing exemplary method embodiments, other exemplary system and computer product embodiments for floating point computation for hybrid formats are provided.

BRIEF DESCRIPTION OF THE DRAWINGS

Figure 1 is a block diagram of a network of data processing systems according to an embodiment of the present invention;
Figure 2 is a block diagram of a data processing system according to an embodiment of the present invention;
Figure 3 depicts a block diagram of an example configuration for floating point unit in accordance with an illustrative embodiment;
Figure 4A is an additional block diagram depicting an exemplary functional relationship in a system for floating point computation without hybrid formats;
Figure 4B is an additional block diagram depicting an exemplary functional relationship in a system for floating point computation for hybrid formats using a simplified superset floating point unit ("ssFPU");
Figure 5 is block flow diagram depicting an exemplary system and functionality for accelerating machine learning in a computing environment by a processor in which aspects of the present invention may be realized;

Figure 6 is a flowchart diagram depicting an exemplary method for performing hybrid precision floating point format computation via a simplified superset floating point unit ("ssFPU") in a computing environment by a processor in which aspects of the present invention may be realized;

Figure 7 is a flowchart diagram depicting an exemplary method for performing hybrid precision floating point format computation via a simplified superset floating point unit ("ssFPU") in a computing environment by a processor in which aspects of the present invention may be realized; and

Figure 8 is a flowchart diagram depicting an exemplary method for performing hybrid precision floating point format computation via a simplified superset floating point unit ("ssFPU") in a computing environment by a processor in a computing environment by a processor, again, in which aspects of the present invention may be realized.

## DETAILED DESCRIPTION

Since computer memory is limited, it is not possible to store numbers with infinite precision, no matter whether the numbers use binary fractions or decimal fractions. At some point a number has to be cut off or rounded off to be represented in a computer memory.

How a number is represented in memory is dependent upon how much accuracy is desired from the representation. Generally, a single way (e.g., a fixed-point representation) of representing numbers with binary bits is unsuitable for the varied applications where those numbers are used. For example, a physicist needs to use numbers to represent the speed of light (about 300000000) as well as numbers that represent Newton's gravitational constant (about 0.0000000000667), possibly together in some applications.

To satisfy different types of applications and their respective needs for accuracy, a general-purpose number format has to be designed so that the format can provide accuracy for numbers at very different magnitudes. However, only relative accuracy is needed. For this reason, a fixed-point representation is not very useful. Floating point representation solves this problem.

A floating point representation resolves a given number into three main parts - (i) a significand that contains the number's digits, (ii) an exponent that sets the location where the decimal (or binary) point is placed relative to the beginning of the significand. Negative exponents represent numbers that are very small (i.e., close to zero), and (iii) a sign (positive or negative) associated with the number.

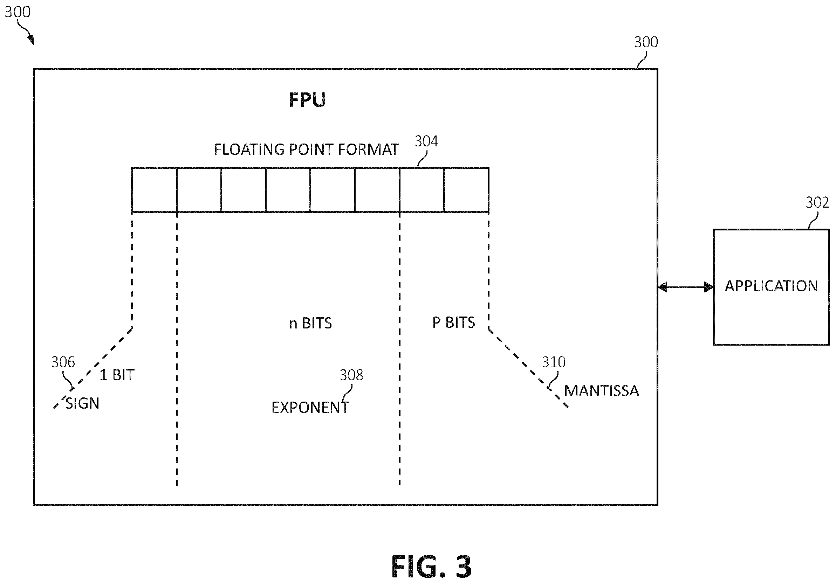

A floating point unit (FPU), as depicted below in Fig. 3, is a processor or part of a processor, implemented as a hardware circuit, that performs floating point calculations. While early FPUs were standalone processors, most are now integrated inside a computer's CPU. Integrated FPUs in modern CPUs are very complex, since they perform high-precision floating point computations while ensuring compliance with the rules governing these computations, as set forth in IEEE floating point standards (IEEE 754).

An FPU has a bit-width. The bit-width is a size, in terms of a number of binary bits used to represent a number in a floating point format (referred to hereinafter as a "format" or "floating point format"). One or more organizations, such as Institute of Electrical and Electronics Engineers (IEEE), have created standards pertaining to floating point formats. The presently used formats provide standard method of representing numbers using 16-bit, 32-bit, 64-bit, and 128-bit formats.

For example, a floating point format may include a sign, an unsigned biased exponent, and a significand. The sign bit is a single bit and is represented by an "S". The unsigned biased exponent, represented by an "e," is (in the formats defined by IEEE 754, for example) 8 bits long for single precision, 11 bits long for double precision and 15 bits long for quadruple precision. The significand is, again, in the IEEE 754 standard, 24 bits long for single precision, 53 bits long for double precision and 113 bits long for quadruple precision. As defined by the IEEE-754-2008 standard, the most significant bit of the significand, i.e., the so called implicit bit, is implied by the value of the exponent bits.

A (1/5/2) (sign-exponent-mantissa) floating-point 8-bit format ("FP8") may be used to successfully train machine learning models without much accuracy loss. While 8-bit training techniques have progressed rapidly, its applicability typically applies only on a small subset of deep learning models. To address this, amongst other inefficiencies of the FP8 format, a hybrid FP8 format and technique may be used that is applicable to both computations (e.g., training and inference) and communication to address all of these challenges.

The hybrid FP8 format may use 4 exponent bits and 3 mantissa bits (1/4/3 with an exponent bias) for forward propagation and 5 exponent bits and 2 mantissa bits (1/5/2) for backward propagation-achieving negligible accuracy degradation on previously problematic models. That is, for the hybrid FP8 format, in the forward pass, an 8-bit floating-point format with 1 sign bit, 4 exponent bits and 3 mantissa bits is used. In the backward pass, for the hybrid FP8 format, an 8-bit floating-point format with 1 sign bit, 5 exponent bits and 2 mantissa bits are used. The 8-bits are used to be compatible with all levels of memory hierarchy.

Also, hybrid FP8 format computations such as, for example, the basic floating point function, which is a fused-multiply-multiply-accumulate ("FMMA") can be observed as the following equation:

$$R = C + A1 * B1 + A2 * B2, \qquad (1),$$

Where *R, C* are in FP16, and the product terms *A*1, *A*2, *B*1, *B*2 are in FP8 (e.g., the 16-bit input for and B is as a two-element pair, with 8 bits per element), 16-bit input for A and B may be a two-element pair with 8 bits per element, and R may be equal to equation 2A:

$$R = \text{round}(\text{align}(C) + \text{align}(A1 * B1 + A2 * B2)) \qquad (2).$$

In the event *A*1, *A*2, *B*1, *B*2 are Hybrid-FP8 numbers, *A*1and *A*2 may be in one format (e.g. the 1/5/2 format) and B1 and B2 may be in another format (e.g. the 1/4/3 format).

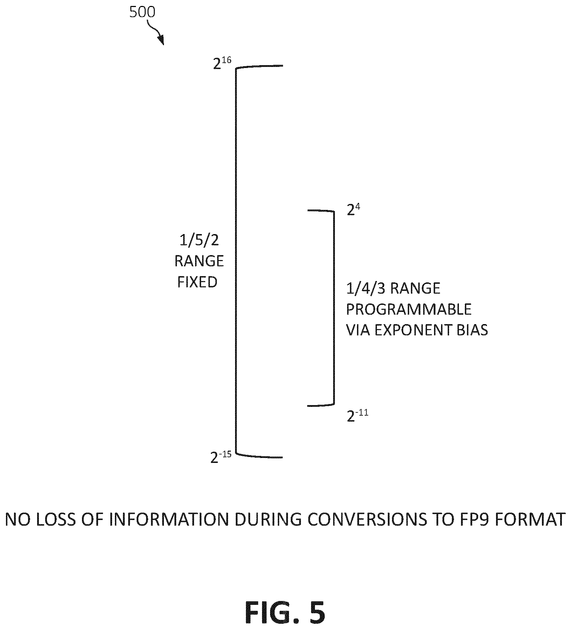

However, despite the convenience of using the Hybrid-FP8 format (allowing some operands in 1/5/2 format and some in 1/4/3 format), current FPUs must determine whether each operand is using the FP8 format (1/5/2 format) and/or the FP8 (1/4/3 format) and then decode each operand appropriately for its format. Current FPU's are now required to include additional logic and functionality to decode the different FP8 formats, which decreases computational efficiency while increasing the processing power, particularly since the same FP8 operand is sent to multiple FPUs and each FPU ends up doing the identical decoding and decoding control signals must also be sent to each FPU. Further, it is desirable for 1/4/3 numbers format to have a programmable exponent bias to compensate for the small dynamic range imposed by having only 4 exponent bits, which is depicted below in Fig. 5. Decoding the programmable exponent bias in each FPU would add more duplicated logic. Thus, the mechanisms of the illustrated embodiments provide an efficient process for implementing computations using both numerical formats (e.g., the FP8 format (1/5/2 format) and/or the FP8 (1/4/3 format)) and eliminating the need for an FPU to decode the different FP8 formats and each receiving decoding control signals.

Accordingly, various embodiments of the present invention provide for efficiently performing hybrid FP8 computations in a systolic array of compute engines. In one aspect, mechanisms of the illustrated embodiments include a conversion engine at entry-points into a systolic array and convert hybrid FP8 numbers into a unified format that is a superset of the FP8 formats (in this case FP9) enabling the compute engines to be more efficient in power, area and delay. The new FPUs (e.g., simplified superset FPUs or "ssFPUs") increase compute density in high-throughput accelerators (for e.g. deep learning accelerators).

In one aspect, the present invention provides for floating point computation for hybrid formats (e.g., performing hybrid precision floating point format computation via a simplified superset floating point unit) in a computing system is provided. One or more inputs, represented as a plurality of floating point number formats, may be converted into a superset floating point format prior to computation by one or more simplified superset floating point units (ssFPUs). Also, the ssFPU may be referred to herein as merely "simplified superset floating point units" ("ssFPU's") or more generally as a "superset floating point unit" ("sFPU"). Thus, any reference to a "superset floating point units" ("sFPU's") is referring to a simplified superset floating point units (ssFPUs) and not to be confused with a reconfigurable FPU.

In one aspect, the superset format uses "max(exponent1, exponent2)" and "max(mantissa1, mantissa2)" as the exponent and mantissa bit-widths such as, for example, the superset format may become a 1/5/3 format. Alternatively, if 1/6/1 and 1/4/3 were the desired memory formats, the superset format would be 1/6/3 or 10-bit floating point. The ssFPU is an FPU that operates only on numbers in the superset format. A compute operation may be performed on the one or more inputs represented as the superset floating point format using the one or more ssFPUs. In one aspect, the superset floating point format may be an 9-bit floating point format ("FP9") comprising a sign bit, exponent bits (e), and mantissa bits (m). The ssFPU's may be a 9-bit floating point unit that only operates on the 9-bit floating point format ("FP9"). That is, the ssFPU operates or computes exclusively on the superset floating point format (e.g., the 9-bit floating point format ("FP9")).

It should be noted, that as used herein, for illustrative convenience, mechanisms of the illustrated embodiments is using a hybrid FP8, but may be equally applicable to any other floating point formats. Also, it should be noted that one or more calculations may be performed for floating point computation and may use various mathematical operations or functions that may involve one or more mathematical operations (e.g., performing rates of change/calculus operations, solving differential equations or partial differential equations analytically or computationally, using addition, subtraction, division, multiplication, standard deviations, means, averages, percentages, statistical modeling using statistical distributions, by finding minimums, maximums or similar thresholds for combined variables, etc.).

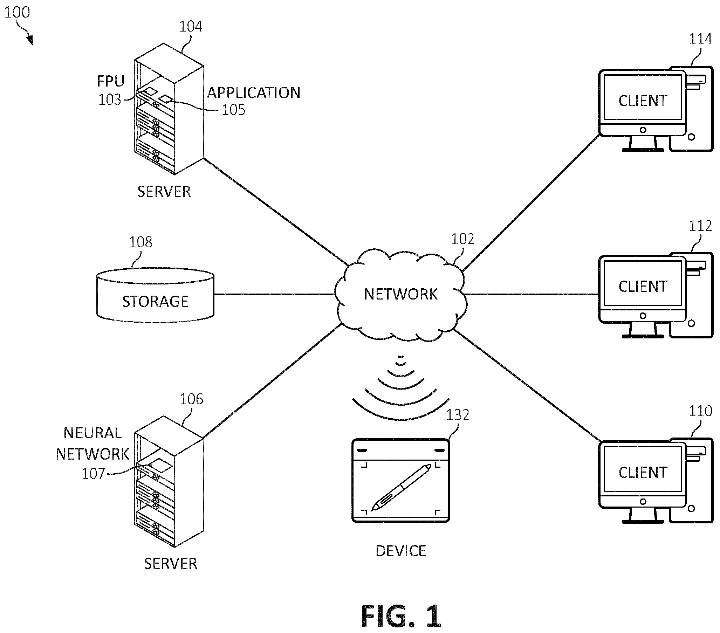

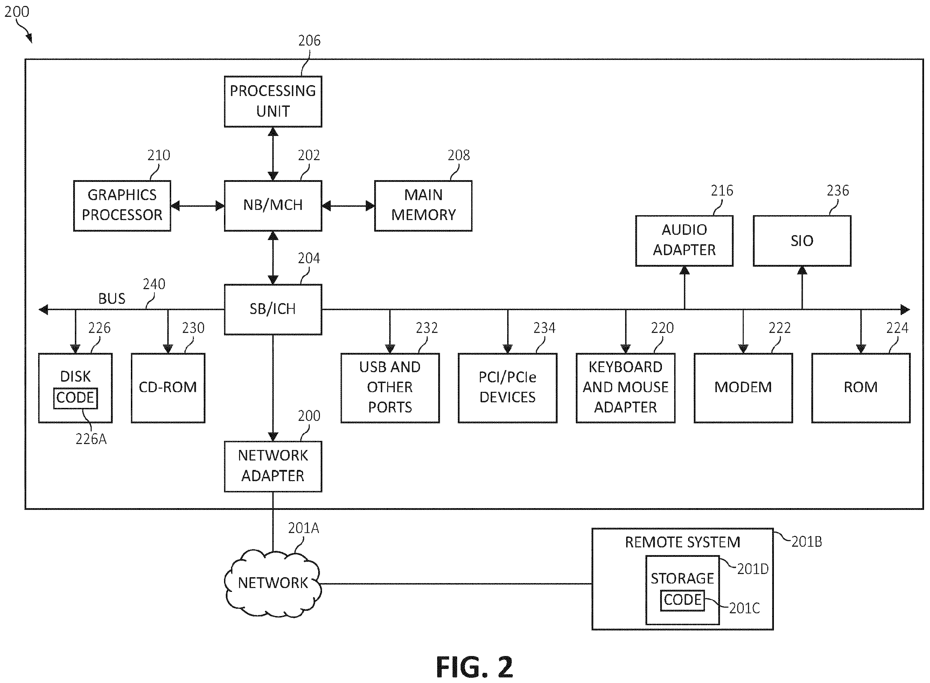

Turning now to Figs. 1 and 2, are diagrams of data processing environments in which illustrative embodiments may be implemented. Figs. 1 and 2 are only examples and are not intended to assert or imply any limitation with regard to the environments in which different embodiments may be implemented. A particular implementation may make many modifications to the depicted environments based on the following description.

Fig. 1 depicts a block diagram of a network of data processing systems in which illustrative embodiments may be implemented. Data processing environment 100 is a network of computers in which the illustrative embodiments may be implemented. Data processing environment 100 includes network 102. Network 102 is the medium used to provide communications links between various devices and computers connected together within data processing environment 100. Network 102 may include connections, such as wire, wireless communication links, or fiber optic cables.

Clients or servers are only example roles of certain data processing systems connected to network 102 and are not intended to exclude other configurations or roles for these data processing systems. Server 104 and server 106 couple to network 102 along with storage unit 108. Software applications may execute on any computer in data processing environment 100. Clients 110, 112, and 114 are also coupled to network 102. A data processing system, such as server 104 or 106, or client 110, 112, or 114 may contain data and may have software applications or software tools executing thereon.

Only as an example, and without implying any limitation to such architecture, Fig. 1 depicts certain components that are usable in an example implementation of an embodiment. For example, servers 104 and 106, and clients 110, 112, 114, are depicted as servers and clients only as examples and not to imply a limitation to a client-server architecture. As another example, an embodiment can be distributed across several data processing systems and a data network as shown, whereas another embodiment can be implemented on a single data processing system within the scope of the illustrative embodiments. Data processing systems 104, 106, 110, 112, and 114 also represent example nodes in a cluster, partitions, and other configurations suitable for implementing an embodiment.

Device 132 is an example of a device described herein. For example, device 132 can take the form of a smartphone, a tablet computer, a laptop computer, client 110 in a stationary or a portable form, a wearable computing device, or any other suitable device. Any software application described as executing in another data processing system in Fig. 1 can be configured to execute in device 132 in a similar manner. Any data or information stored or produced in another data processing system in Fig. 1 can be configured to be stored or produced in device 132 in a similar manner.

Assume that FPU 103 is a modified FPU according to an embodiment and is configured to operate in server 104. For example, server 104 may be participating in training or configuring neural network 107. Application 105 implements an operating component to configure FPU 103, provide program instructions to FPU 103, or otherwise operate FPU 103 for training neural network 107 or for other floating point computations. Application 105 can be implemented in hardware, software, or firmware. Application 105 can be implemented within FPU 103, outside FPU 103 but in server 104, or even outside server 104 in another data processing system across data network 102, e.g., in server 106.

Servers 104 and 106, storage unit 108, and clients 110, 112, and 114, and device 132 may couple to network 102 using wired connections, wireless communication protocols, or other suitable data connectivity. Clients 110, 112, and 114 may be, for example, personal computers or network computers.

In the depicted example, server 104 may provide data, such as boot files, operating system images, and applications to clients 110, 112, and 114. Clients 110, 112, and 114 may be clients to server 104 in this example. Clients 110, 112, 114, or some combination thereof, may include their own data, boot files, operating system images, and applications. Data processing environment 100 may include additional servers, clients, and other devices that are not shown.

In the depicted example, data processing environment 100 may be the Internet. Network 102 may represent a collection of networks and gateways that use the Transmission Control Protocol/Internet Protocol (TCP/IP) and other protocols to communicate with one another. At the heart of the Internet is a backbone of data communication links between major nodes or host computers, including thousands of commercial, governmental, educational, and other computer systems that route data and messages. Of course, data processing environment 100 also may be implemented as a number of different types of networks, such as for example, an intranet, a local area network (LAN), or a wide area network (WAN). Fig. 1 is intended as an example, and not as an architectural limitation for the different illustrative embodiments.

Among other uses, data processing environment 100 may be used for implementing a client-server environment in which the illustrative embodiments may be implemented. A client-server environment enables software applications and data to be distributed across a network such that an application functions by using the interactivity between a client data processing system and a server data processing system. Data processing environment 100 may also employ a service oriented architecture where interoperable software components distributed across a network may be packaged together as coherent business applications. Data processing environment 100 may also take the form of a cloud, and employ a cloud computing model of service delivery for enabling convenient, on-demand network access to a shared pool of configurable computing resources (e.g., networks, network bandwidth, servers, processing, memory, storage, applications, virtual machines, and services) that can be rapidly provisioned and released with minimal management effort or interaction with a provider of the service.

With reference to Fig. 2, Fig. 2 depicts a block diagram of a data processing system in which illustrative embodiments may be implemented. Data processing system 200 is an example of a computer, such as servers 104 and 106, or clients 110, 112, and 114 in Fig. 1, or another type of device in which computer usable program code or instructions implementing the processes may be located for the illustrative embodiments.

Data processing system 200 is also representative of a data processing system or a configuration therein, such as data processing system 132 in Fig. 1 in which computer usable program code or instructions implementing the processes of the illustrative embodiments may be located. Data processing system 200 is described as a computer only as an example, without being limited thereto. Implementations in the form of other devices, such as device 132 in Fig. 1, may modify data processing system 200, such as by adding a touch interface, and even eliminate certain depicted components from data processing system 200 without departing from the general description of the operations and functions of data processing system 200 described herein.

In the depicted example, data processing system 200 employs a hub architecture including North Bridge and memory controller hub (NB/MCH) 202 and South Bridge and input/output (I/O) controller hub (SB/ICH) 204. Processing unit 206, main memory 208, and graphics processor 210 are coupled to North Bridge and memory controller hub (NB/MCH) 202. Processing unit 206 may contain one or more processors and may be implemented using one or more heterogeneous processor systems. Processing unit 206 may be a multi-core processor. Graphics processor 210 may be coupled to NB/MCH 202 through an accelerated graphics port (AGP) in certain implementations.

In the depicted example, local area network (LAN) adapter 212 is coupled to South Bridge and I/O controller hub (SB/ICH) 204. Audio adapter 216, keyboard and mouse adapter 220, modem 222, read only memory (ROM) 224, universal serial bus (USB) and other ports 232, and PCI/PCIe devices 234 are coupled to South Bridge and I/O controller hub 204 through bus 238. Hard disk drive (HDD) or solid-state drive (SSD) 226 and CD-ROM 230 are coupled to South Bridge and I/O controller hub 204 through bus 240. PCI/PCIe devices 234 may include, for example, Ethernet adapters, add-in cards, and PC cards for notebook computers. PCI uses a card bus controller, while PCIe does not. ROM 224 may be, for example, a flash binary input/output system (BIOS). Hard disk drive 226 and CD-ROM 230 may use, for example, an integrated drive electronics (IDE), serial advanced technology attachment (SATA) interface, or variants such as external-SATA (eSATA) and micro- SATA (mSATA). A super I/O (SIO) device 236 may be coupled to South Bridge and I/O controller hub (SB/ICH) 204 through bus 238.

Memories, such as main memory 208, ROM 224, or flash memory (not shown), are some examples of computer usable storage devices. Hard disk drive or solid state drive 226, CD-ROM 230, and other similarly usable devices are some examples of computer usable storage devices including a computer usable storage medium.

An operating system runs on processing unit 206. The operating system coordinates and provides control of various components within data processing system 200 in Fig. 2. The operating system may be a commercially available operating system for any type of computing platform, including but not limited to server systems, personal computers, and mobile devices. An object oriented or other type of programming system may operate in conjunction with the operating system and provide calls to the operating system from programs or applications executing on data processing system 200.

Instructions for the operating system, the object-oriented programming system, and applications or programs, such as application 105 in Fig. 1, are located on storage devices, such as in the form of code 226A on hard disk drive 226, and may be loaded into at least one of one or more memories, such as main memory 208, for execution by processing unit 206. The processes of the illustrative embodiments may be performed by processing unit 206 using computer implemented instructions, which may be located in a memory, such as, for example, main memory 208, read only memory 224, or in one or more peripheral devices.

Furthermore, in one case, code 226A may be downloaded over network 201A from remote system 201B, where similar code 201C is stored on a storage device 201D. in another case, code 226A may be downloaded over network 201A to remote system 201B, where downloaded code 201C is stored on a storage device 201D.

The hardware in Figures 1-2 may vary depending on the implementation. Other internal hardware or peripheral devices, such as flash memory, equivalent non-volatile memory, or optical disk drives and the like, may be used in addition to or in place of the hardware depicted in Figures 1-2. In addition, the processes of the illustrative embodiments may be applied to a multiprocessor data processing system.

In some illustrative examples, data processing system 200 may be a personal digital assistant (PDA), which is generally configured with flash memory to provide non-volatile memory for storing operating system files and/or user-generated data. A bus system may comprise one or more buses, such as a system bus, an I/O bus, and a PCI bus. Of course, the bus system may be implemented using any type of communications fabric or architecture that provides for a transfer of data between different components or devices attached to the fabric or architecture.

A communications unit may include one or more devices used to transmit and receive data, such as a modem or a network adapter. A memory may be, for example, main memory 208 or a cache, such as the cache found in North Bridge and memory controller hub 202. A processing unit may include one or more processors or CPUs.

The depicted examples in Figs. 1-2 and above-described examples are not meant to imply architectural limitations. For example, data processing system 200 also may be a tablet computer, laptop computer, or telephone device in addition to taking the form of a mobile or wearable device.

Where a computer or data processing system is described as a virtual machine, a virtual device, or a virtual component, the virtual machine, virtual device, or the virtual component operates in the manner of data processing system 200 using virtualized manifestation of some or all components depicted in data processing system 200. For example, in a virtual machine, virtual device, or virtual component, processing unit 206 is manifested as a virtualized instance of all or some number of hardware processing units 206 available in a host data processing system, main memory 208 is manifested as a virtualized instance of all or some portion of main memory 208 that may be available in the host data processing system, and disk 226 is manifested as a virtualized instance of all or some portion of disk 226 that may be available in the host data processing system. The host data processing system in such cases is represented by data processing system 200.

It is understood in advance that although this disclosure includes a detailed description on various computing systems, the systems may include cloud computing and implementation of the teachings recited herein are not limited to a cloud computing environment. Rather, embodiments of the present invention are capable of being implemented in conjunction with any other type of computing environment now known or later developed.

Cloud computing is a model of service delivery for enabling convenient, on-demand network access to a shared pool of configurable computing resources (e.g. networks, network bandwidth, servers, processing, memory, storage, applications, virtual machines, and services) that can be rapidly provisioned and released with minimal management effort or interaction with a provider of the service. This cloud model may include at least five characteristics, at least three service models, and at least four deployment models.

Characteristics are as follows:

On-demand self-service: a cloud consumer can unilaterally provision computing capabilities, such as server time and network storage, as needed automatically without requiring human interaction with the service's provider.

Broad network access: capabilities are available over a network and accessed through standard mechanisms that promote use by heterogeneous thin or thick client platforms (e.g., mobile phones, laptops, and PDAs).

Resource pooling: the provider's computing resources are pooled to serve multiple consumers using a multi-tenant model, with different physical and virtual resources dynamically assigned and reassigned according to demand. There is a sense of location independence in that the consumer generally has no control or knowledge over the exact location of the provided resources but may be able to specify location at a higher level of abstraction (e.g., country, state, or datacenter).

Rapid elasticity: capabilities can be rapidly and elastically provisioned, in some cases automatically, to quickly scale out and rapidly released to quickly scale in. To the consumer, the capabilities available for provisioning often appear to be unlimited and can be purchased in any quantity at any time.

Measured service: cloud systems automatically control and optimize resource use by leveraging a metering capability at some level of abstraction appropriate to the type of service (e.g., storage, processing, bandwidth, and active user accounts). Resource usage can be monitored, controlled, and reported providing transparency for both the provider and consumer of the utilized service.

Service Models are as follows:

Software as a Service (SaaS): the capability provided to the consumer is to use the provider's applications running on a cloud infrastructure. The applications are accessible from various client devices through a thin client interface such as a web browser (e.g., web-based e- mail). The consumer does not manage or control the underlying cloud infrastructure including network, servers, operating systems, storage, or even individual application capabilities, with the possible exception of limited user-specific application configuration settings.

Platform as a Service (PaaS): the capability provided to the consumer is to deploy onto the cloud infrastructure consumer-created or acquired applications created using programming languages and tools supported by the provider. The consumer does not manage or control the underlying cloud infrastructure including networks, servers, operating systems, or storage, but has control over the deployed applications and possibly application hosting environment configurations.

Infrastructure as a Service (IaaS): the capability provided to the consumer is to provision processing, storage, networks, and other fundamental computing resources where the consumer is able to deploy and run arbitrary software, which can include operating systems and applications. The consumer does not manage or control the underlying cloud infrastructure but has control over operating systems, storage, deployed applications, and possibly limited control of select networking components (e.g., host firewalls).

Deployment Models are as follows:

Private cloud: the cloud infrastructure is operated solely for an organization. It may be managed by the organization or a third party and may exist on-premises or off-premises.

Community cloud: the cloud infrastructure is shared by several organizations and supports a specific community that has shared concerns (e.g., mission, security requirements, policy, and compliance considerations). It may be managed by the organizations or a third party and may exist on-premises or off-premises.

Public cloud: the cloud infrastructure is made available to the general public or a large industry group and is owned by an organization selling cloud services.

Hybrid cloud: the cloud infrastructure is a composition of two or more clouds (private, community, or public) that remain unique entities but are bound together by standardized or proprietary technology that enables data and application portability (e.g., cloud bursting for load-balancing between clouds).

A cloud computing environment is service oriented with a focus on statelessness, low coupling, modularity, and semantic interoperability. At the heart of cloud computing is an infrastructure comprising a network of interconnected nodes.

Referring now to Fig. 3, this figure depicts a block diagram of an example configuration for floating point representation in accordance with an illustrative embodiment. FPU 300 is an example of FPU 103 in Fig. 1. Application 302 is an example of application 105 in Fig. 1.

Application 302 configures memory bits in FPU 300 as floating point format 304. Format 304 is configured using 8 bits as a non-limiting example described herein. In an embodiment, highest 1 bit is reserved as sign bit 306, next lower 5 bits are reserved as exponent bits 308, and the lowest 2 bits are reserved as mantissa bits 310. In an embodiment (not shown), highest 1 bit is reserved as sign bit 306, next lower 4 bits are reserved as exponent bits 308, and the lowest bits are reserved as 3 mantissa bits 310.

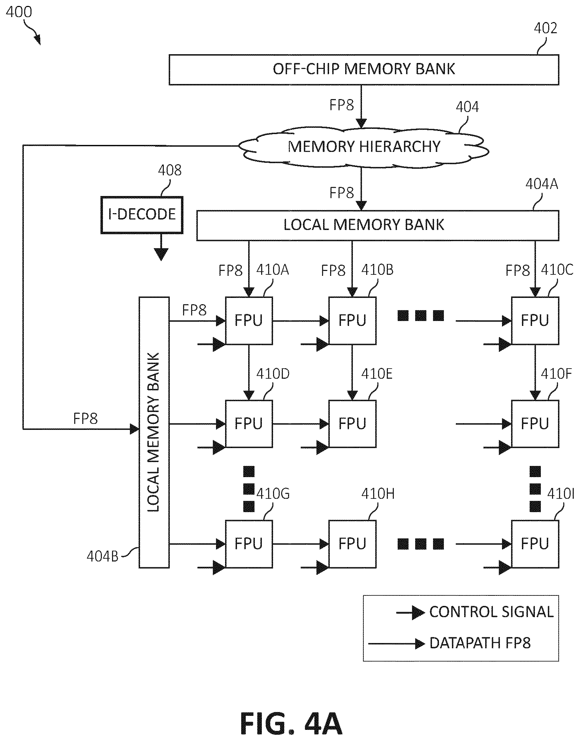

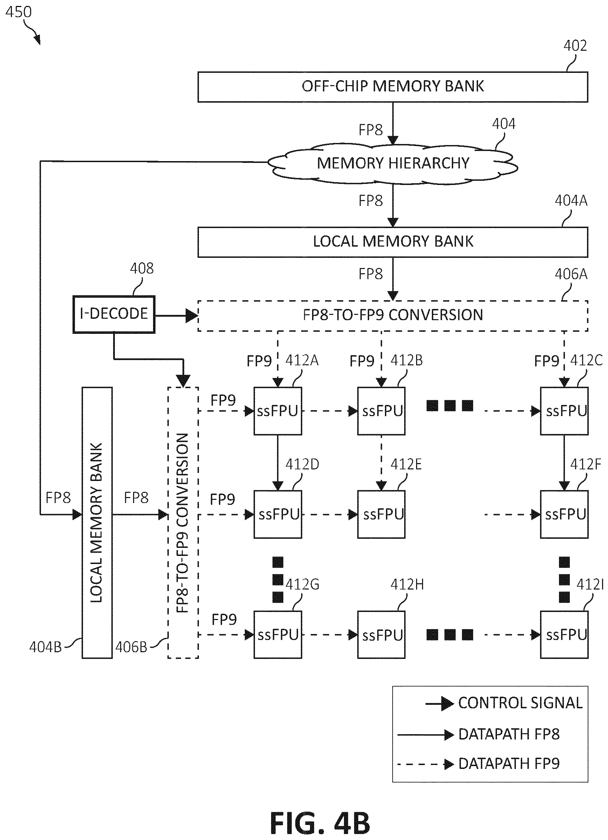

Turning now to Fig. 4A-4B, are block diagram depicting exemplary functional components of system 400 (e.g., an accelerator) floating point computation without hybrid formats (e.g., Fig.4A) and for hybrid formats using a simplified superset floating point unit ("ssFPU") (e.g., Fig. 4B) in a computing environment according to various mechanisms of the illustrated embodiments is shown. In one aspect, one or more of the components, modules, services, applications, and/or functions described in Figs. 1-3 may be used in Figs. 4A-4B. As will be seen, many of the functional blocks may also be considered "modules" or "components" of functionality, in the same descriptive sense as has been previously described in Figs. 1-3.

As depicted, in Figs. 4A, system 400 may include an off-chip memory bank 402, a memory hierarchy 404, one or more memory banks such as, for example, local memory banks 404A and 404B, and one or more FPU's 410A-I (e.g., an array of FPU's). In one aspect, the system 400 may be an accelerator.

In operation, assume for example, that the some FP8 operands (e.g., $A1$ and/or $A2$ in FP8 format from equation 1) are generated and flow from the off-chip memory bank 402 (and vertically from the memory hierarchy 404) into the local memory bank 404A. Also, assume the FP8 operations (e.g., $B1$ and/or $B2$ in FP8 format from equation 1) are generated and flow from the off-chip memory bank 402 (and horizontally from the memory hierarchy 404) into the local memory bank 404B into the array of FPU's 410A-I. At this point, each of the FP8 operands are in a memory storage format and not in a computation format.

Each of the FP8 operands are provided as input operands into the array of FPU's 410A-I from the local memory banks 404A and 404B, where some of the FP8 operands are FP8 datapaths. It should be noted that FP16 operands may be present and provided as input operands but are not illustrated here for illustrative convenience.

Control signals, produced and generated by the "I-decode" block, may be sent along with each of the FP8 operands (e.g., A's or B's) to indicate to the FPUs 410A-I if the FP8 operands are in the 1/5/2 form (e.g., sign + 5 exponent bits + 2 mantissa bits) or the 1/4/3 form (e.g., sign + 4 exponent bits + 3 mantissa bits).

The systolic array of FPU's 410A-I pass the operands and results to each other to perform matrix-multiplication/computation. For example, the FPU's 410A-I receive the FP8 operands (and FP16 operands) in the datapath. Bits in the control path may signal the format of the FP8 numbers and the FPU computation is determined by the control path signals. Thus, each of the FPU's 410A-I may be analyzing the same bits of the FP8 operands and perform the same decode of the data bits to determine operations based on the format (e.g., 1/5/2 or 1/4/3 format).

Thus the challenges of the current arrangement depicted in Fig. 4A, is that the each FPU's 410A-I requires additional functionality (e.g., compute logic) to decode two different FP8 formats (e.g., 1/5/2 or 1/4/3 format), which increases the power requirements and overall computing delay causing computing inefficiencies. The bias of both formats are fixed, which may be sufficient for the 1/5/2 format, but not for the 1/4/3 format). That is, the bias of both formats are fixed due to the difficulty in sending the otherwise variable bias (as part of the control signal) to all the FPUs each time an operand is sent. In common workloads, the same FP8 operand (e.g., the same input operand) is sent to multiple FPU's 410A-I, which means multiple FPU's 410A-I are required to do identical decoding operations.

In order to eliminate these inefficiencies and perform floating point computation for hybrid formats, Fig. 4B uses a different FPU such as, for example, a simplified superset floating point unit ("ssFPU") and one or more conversion units such as, for example, conversion unit 404A and 404B.

First, prior to sending the FP8 operands to the systolic array of simplified superset FPU's ("ssFPU's") 412A-1, the FP8 operands are passed from the local memory banks 404A and 404B into a conversion unit (e.g., FP8-FP9 conversion) such as, for example, the conversion units 404A and 404B.

Here the conversion units 404A and 404B may convert both FP8 formats (e.g., 1/5/2 and 1/4/3) into a superset format (e.g., such as, for example, a FP9 format) at the input interface of the array of compute units (e.g., the array of ssFPU's 412A-I). The memory such as, for example, local memory bank 404A, 404B and off-chip memory bank 402, continues to store data in FP8 format with all the architecture included in the memory hierarchy 404 also being in the FP8 format.

The conversion units 404A and 404B may identify and distinguish the floating point number formats (e.g., the FP8 format) of the input operands as a very low precision ("VLP") format comprising a sign bit, exponent bits (e), and mantissa bits (m). The VLP may be an 8- bit floating point format ("FP8") and identify the superset floating point format as a single floating point format.

The superset floating point format may be a 9-bit floating point format ("FP9") comprising a sign bit, exponent bits (e), and mantissa bits (m). The ssFPU's 412A-I may be a 9-bit floating point unit.

Each of the conversion units 404A and 404B (e.g., FP8-FP9 conversion/compute units) may perform the conversions with control signals, from the I-decode unit 408 indicating control information as to whether the input format is 1/5/2 or 1/4/3. Also, the control signals are no longer required (or even sent) to each of the ssFPU's 412A-I, but rather are sent to the conversion units 404A and 404B. The conversion units 404A and 404B then sends the superset format (e.g., FP9 format) to each of the ssFPU's 412A-I. In this way, the superset FPUs such as, for example, the ssFPU's 412A-I no longer have to perform the same decode operations on the same data bits to identify and may distinguish the format of the FP8 compared to the superset format FP9, since the ssFPU's 412A-I now receive only the superset format (e.g., FP9 format).

Again, the FP8 operands (e.g., $A1$ and/or $A2$ in FP8 format from equation 1) that are generated and flow from the off-chip memory bank 402 into the local memory bank 404A vertically and the FP8 operations (e.g., $B1$ and/or $B2$ in FP8 format from equation 1) that are generated and flow from the off-chip memory bank 402 into the local memory bank 404B horizontally remain in the FP8 format. The FP8 operands are converted into the superset format only after being sent to the conversion units 404A and 404B.

Thus, the instruction opcode specifies an FP8 fused-multiply accumulate, bits in the instruction specify whether the input FP8 operands are 1/5/2 or 1/4/3 format. Based on these bits, the conversion units 404A and 404B (e.g., FP8-FP9 conversion/compute units) performs the desired conversion into the superset format (e.g., FP9 format) for use by the ssFPU's 412A- I.

It should be noted that a compute operation may be performed on the input operands that are now represented as the superset floating point format using an array of a plurality of the ssFPU's 412A-I.

It should be noted that in the 1/5/2 format of the FP8 format, there are 5 exponent bits with a range of $2^{31}$ as depicted in Fig. 5 showing the 1/5/2 range spanning $2^{-15}$ to $2^{16}$. However, if the FP8 format is 1/4/3, there is only a range of $2^{15}$ (e.g., where the range spans $2^{-7}$ to $2^8$), which is a restricting range. Thus, to overcome the restrictions created by the 1/4/3 format with the exponent bits ranging from $2^{-7}$ to $2^8$, a sliding window may be applied for programing of the 1/4/3 via the exponent bias where subtracting 4 (e.g., -4) from the range of $2^{-7}$ to $2^8$ may now yield a $2^{-11}$ to $2^4$ range.

Thus, the superset format is created by converting the FP8 to FP9 format. For example, the 1/5/2 format is converted to the 1/5/3 with 1-sign bit, 5 exponent bits and 3 mantissa bits. The 1/5/2 format may be converted by adding "0" to the end except when the 1/5/2 input is infinity. Also, the 1/4/3 format may be converted to the 1/5/3 format. A programmable bias for 1/4/3 controls the bias for 1/4/3 and a range of allowed biases (e.g., the sliding range of exponent bias) may be used so as to stay within the bounds of our 1/5/3 dynamic range. It should be noted that since the exponent range of the basic 1/4/3 format is $2^{-7}$ to $2^8$, any bias in the range -8 to +8 (inclusive) will result in an exponent from $2^{-15}$ to $2^{16}$ and will be representable in the 1/5/3 format. The exponent range after an example bias of -4 is applied to a number in the 1/4/3 format ($2^{-11}$ to $2^4$ ) is depicted in Fig. 5.

Accordingly, the mechanism of the illustrated embodiments provide for converting numbers represented via a multitude of floating point number formats into a single floating point format prior to computation via an ssFPU or an array of ssFPUs. The computation format (e.g., the superset format or "FP9" format) may be distinguished from the communication/storage format (e.g., memory storage format or FP8 format), since communication/storage formats are usually constrained to be a power of 2, while computation formats are not similarly constrained.

The array of ssFPUs may perform operations on the same input operands and conversions can be performed at the edge of the array to reduces ssFPU logic depth (no conversions in FPU and avoids on-the-fly reconfiguration. That is, the ssFPU's are FP9 FPU's and distinguishable from reconfigurable FPUs. That is, the ssFPU's are not reconfigurable FPUs.

Using the superset format (e.g., the FP9) enables FP8 format-based training of deep learning networks that requires 2 different formats for computation by merging them to one internal computation format (e.g., the superset format) thereby decreasing hardware costs and increases energy efficiency. The computation format (e.g., the superset format) may be chosen to be a superset of the formats (e.g., 1/5/2 or 1/4/3) being replaced, to prevent rounding errors prior to computation.

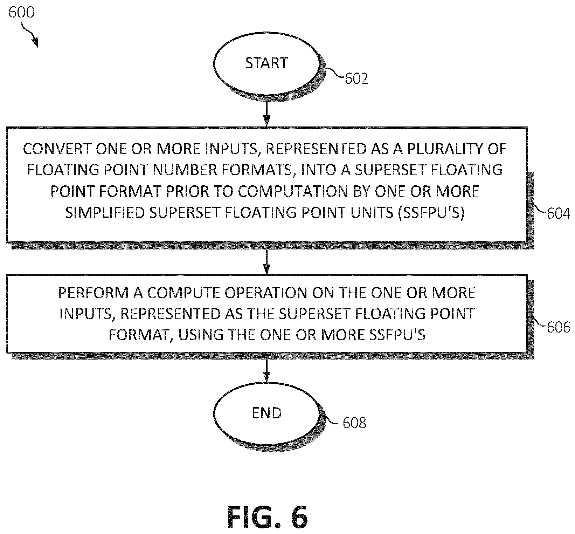

Turning now to Fig. 6, a method 600 for performing hybrid precision floating point format computation via a simplified superset floating point unit in a computing system is depicted, in which various aspects of the illustrated embodiments may be implemented. The functionality 600 may be implemented as a method (e.g., a computer-implemented method) executed as instructions on a machine, where the instructions are included on at least one computer readable medium or one non-transitory machine-readable storage medium. The functionality 600 may start in block 602.

One or more inputs, represented as a plurality of floating point number formats, may be converted into a superset floating point format (e.g., an FP9 format) prior to computation by one or more simplified superset floating point units (ssFPUs). A compute operation may be performed on the one or more inputs represented as the superset floating point format using the one or more ssFPUs, as in block 606. The functionality 600 may end, as in block 608.

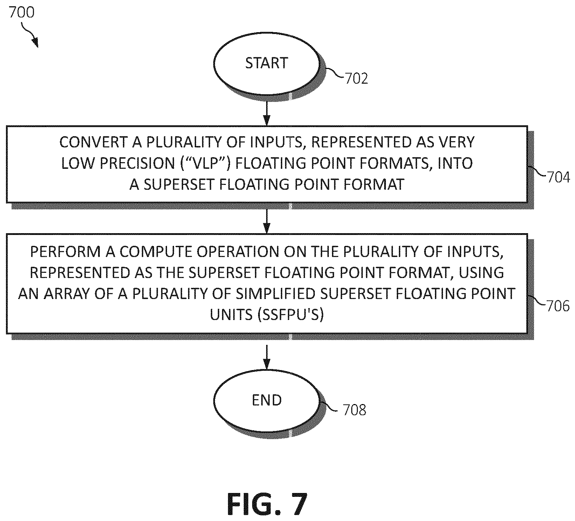

Turning now to Fig. 7, an additional method 700 for performing hybrid precision floating point format computation via a simplified superset floating point unit in a computing system is depicted. The functionality 700 may be implemented as a method (e.g., a computer- implemented method) executed as instructions on a machine, where the instructions are included on at least one computer readable medium or one non-transitory machine-readable storage medium. The functionality 700 may start in block 702.

A plurality of inputs, represented as very low precision ("VLP") floating point formats, may be converted into a superset floating point format, as in block 704. A compute operation may be performed on the plurality of inputs, represented as the superset floating point format, using an array of a plurality of ssFPUs, as in block 706. The functionality 700 may end, as in block 708.

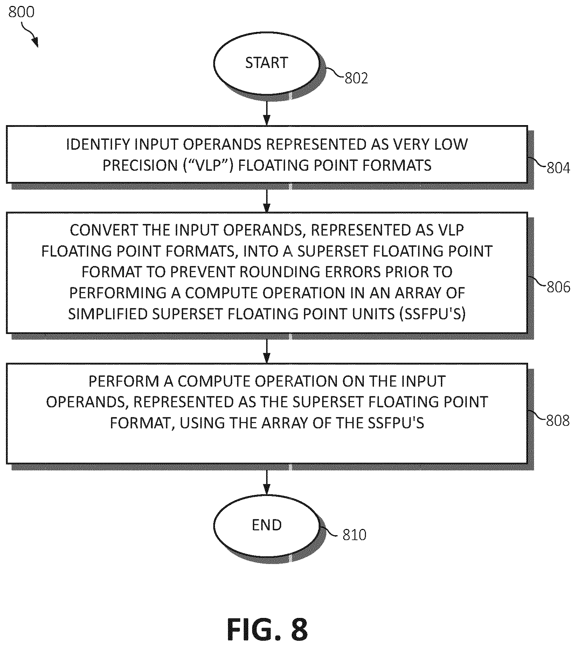

Turning now to Fig. 8, an additional method 800 for performing hybrid precision floating point format computation via a simplified superset floating point unit in a computing system is depicted. The functionality 800 may be implemented as a method (e.g., a computer- implemented method) executed as instructions on a machine, where the instructions are included on at least one computer readable medium or one non-transitory machine-readable storage medium. The functionality 800 may start in block 802.

Input operands, represented as very low precision ("VLP") floating point formats (e.g., memory storage format), may be identified, as in block 804. The input operands, represented as VLP floating point formats, may be converted into a superset floating point format (e.g., a computing format) to prevent rounding errors prior to performing a compute operation in an array of ssFPUs, as in block 806. A compute operation may be performed on the input operands, represented as the superset floating point format, using an array of a plurality of ssFPUs, as in block 806. The functionality 800 may end, as in block 808.

In one aspect, in conjunction with and/or as part of at least one blocks of Figs. 6-8, the operations of 600, 700, and/or 800 may include each of the following.

The operations of 600, 700, and/or 800 may receive both FP8 format operands and a control signal. The operations of 600, 700, and/or 800 may analyze the control signal and decode and convert FP8 format operands into a superset format operands (using a conversion unit). The operations of 600, 700, and/or 800 may send the superset format operands (e.g., FP9 operands) to one or more ssFPU's without sending a control signal (e.g., the control signal is no longer necessary for the ssFPU's since the ssFPU's are able to distinguish and identify the superset format).

The operations of 600, 700, and/or 800 may identify the plurality of floating point number formats as a very low precision ("VLP") format comprising a sign bit, exponent bits (e), and mantissa bits (m), wherein the VLP is an 8-bit floating point format ("FP8") and identify the superset floating point format as a single floating point format. The superset floating point format is an 9-bit floating point format ("FP9") comprising a sign bit, exponent bits (e), and mantissa bits (m) and the one or more ssFPUs is 9-bit floating point unit.

The operations of 600, 700, and/or 800 may convert the one or more inputs, represented as a plurality of 8-bit floating point formats ("FP8") into the superset floating point format prior to computation by the one or more ssFPUs. The superset floating point format may be an 9-bit floating point format ("FP9") and the one or more ssFPUs may be a 9-bit floating point unit.

The operations of 600, 700, and/or 800 may determine the plurality of floating point number formats as being a memory storage format and the superset floating point format is a computation format.

The operations of 600, 700, and/or 800 may perform the conversion of the one or more inputs, represented as a plurality of 8-bit floating point formats ("FP8") into the superset floating point format at an edge of an array of the one or more ssFPUs and simultaneously perform the compute operation on the one or more inputs represented as the superset floating point format using the array of the one or more ssFPUs.

The operations of 600, 700, and/or 800 may merge the plurality of floating point number formats for the converting into the superset floating point format to perform the compute operation to enable very low precision ("VLP") machine learning training in a machine learning operation.

The operations of 600, 700, and/or 800 may prevent rounding errors prior to the compute operation by selecting the superset floating point format to replace the plurality of floating point number formats.

The present invention may be a system, a method, and/or a computer program product. The computer program product may include a computer readable storage medium (or media) having computer readable program instructions thereon for causing a processor to carry out aspects of the present invention.

The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device.

Computer readable program instructions for carrying out operations of the present invention may be assembler instructions, instruction-set-architecture (ISA) instructions, machine instructions, machine dependent instructions, microcode, firmware instructions, state- setting data, or either source code or object code written in any combination of one or more programming languages, including an object oriented programming language such as Smalltalk, C++ or the like, and conventional procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present invention.

Aspects of the present invention are described herein with reference to flowchart illustrations and/or block diagrams of methods, apparatus (systems), and computer program products according to embodiments of the invention. It will be understood that each block of the flowchart illustrations and/or block diagrams, and combinations of blocks in the flowchart illustrations and/or block diagrams, can be implemented by computer readable program instructions.

These computer readable program instructions may be provided to a processor of a general-purpose computer, special purpose computer, or other programmable data processing apparatus to produce a machine, such that the instructions, which execute via the processor of the computer or other programmable data processing apparatus, create means for implementing the functions/acts specified in the flowcharts and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the function/act specified in the flowcharts and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowcharts and/or block diagram block or blocks.

The flowcharts and block diagrams in the Figures illustrate the architecture, functionality, and operation of possible implementations of systems, methods, and computer program products according to various embodiments of the present invention. In this regard, each block in the flowcharts or block diagrams may represent a module, segment, or portion of instructions, which comprises one or more executable instructions for implementing the specified logical function(s). In some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustrations, and combinations of blocks in the block diagrams and/or flowchart illustrations, can be implemented by special purpose hardware-based systems that perform the specified functions or acts or carry out combinations of special purpose hardware and computer instructions.

The descriptions of the various embodiments of the present invention have been presented for purposes of illustration, but are not intended to be exhaustive or limited to the embodiments disclosed. Many modifications and variations will be apparent to those of ordinary skill in the art without departing from the scope of the described embodiments. The terminology used herein was chosen to best explain the principles of the embodiments, the practical application or technical improvement over technologies found in the marketplace, or to enable others of ordinary skill in the art to understand the embodiments disclosed herein.

**Claims**

1. A computer implemented method for performing hybrid precision floating point format computation via a simplified superset floating point unit by one or more processors comprising:

   converting (604) one or more inputs, represented as a plurality of floating point number formats (300), into a superset floating point format prior to computation by one or more simplified superset floating point units, ssFPUs (412);
   performing (606) a compute operation on the one or more inputs represented as the superset floating point format using the one or more ssFPUs; identifying (804) the plurality of floating point number formats as a very low precision, VLP, format comprising a sign bit (306), exponent bits (308), and mantissa bits (310), wherein the VLP is an 8-bit floating point format; and
   identifying the superset floating point format as a single floating point format, wherein the superset floating point format is a 9-bit floating point format comprising a sign bit, exponent bits, and mantissa bits and the one or more ssFPUs is a 9-bit floating point unit.

2. The method of claim 1, further including converting (806) the one or more inputs, represented as a plurality of 8-bit floating point formats into the superset floating point format prior to computation by the one or more ssFPUs.

3. The method of any preceding claim, further including determining the plurality of floating point number formats as being a memory storage format and the superset floating point format is a computation format.

4. The method of claim 1, further including:

   performing (808) the converting of the one or more inputs, represented as a plurality of 8-bit floating point formats (300) into the superset floating point format at an edge of the one or more ssFPUs; and
   simultaneously performing (616) the compute operation on the one or more inputs represented as the superset floating point format using the one or more ssFPUs.

5. The method of claim 1, further including merging the plurality of floating point number formats for the converting into the superset floating point format to perform the compute operation to enable very low precision machine learning training in a machine learning operation.

6. The method of claim 1, further including preventing rounding errors prior to the compute operation by selecting the superset floating point format to replace the plurality of floating point number formats.

7. A system for performing hybrid precision floating point format computation via a simplified superset floating point unit (412) in a computing environment (200), comprising:
   one or more computers with executable instructions that when executed cause the system to:

   convert (604) one or more inputs, represented as a plurality of floating point number formats, into a superset floating point format prior to computation by one or more simplified superset floating point units, ssFPUs;
   performing (606) a compute operation on the one or more inputs represented as the superset floating point format using the one or more ssFPUs;
   identifying the plurality of floating point number formats as a very low precision, VLP, format comprising a sign bit (306), exponent bits (308), and mantissa bits (310), wherein the VLP is an 8- bit floating point format; and
   identifying the superset floating point format as a single floating point format,
   wherein the superset floating point format is a 9-bit floating point format comprising a sign bit, exponent bits, and mantissa bits and the one or more ssFPUs is a 9-bit floating point unit.

8. The system of claim 7, wherein the executable instructions when executed cause the system to convert the one or more inputs, represented as a plurality of 8-bit floating point formats into the superset floating point format prior to computation by the one or more ssFPUs.

9. The system of either of claims 7 or 8, wherein the executable instructions when executed cause the system to determine the plurality of floating point number formats as being a memory storage format and the superset floating point format is a computation format.

10. The system of claim 7, wherein the executable instructions when executed cause the system to:

perform the converting of the one or more inputs, represented as a plurality of 8-bit floating point formats into the superset floating point format at an edge of the one or more ssFPUs; and
simultaneously perform the compute operation on the one or more inputs represented as the superset floating point format using the one or more ssFPUs.

11. The system of claim 7, wherein the executable instructions when executed cause the system to merge the plurality of floating point number formats for the converting into the superset floating point format to perform the compute operation to enable very low precision machine learning training in a machine learning operation.

12. The system of claim 7, wherein the executable instructions when executed cause the system to prevent rounding errors prior to the compute operation by selecting the superset floating point format to replace the plurality of floating point number formats.

13. A computer program product for performing hybrid precision floating point format computation via a simplified superset floating point unit, the computer program product comprising: a computer readable storage medium readable by a processing circuit and storing instructions for execution by the processing circuit for performing a method according to any of claims 1 to 6.

14. A computer program stored on a computer readable medium and loadable into the internal memory of a digital computer, comprising software for performing the method of any of claims 1 to 6, when said program is run on a computer.

**Patentansprüche**

1. Computerrealisiertes Verfahren zum Durchführen von Gleitkommaformat-Berechnungen mit hybrider Genauigkeit über eine vereinfachte Obermengen-Gleitkommaeinheit durch einen oder mehrere Prozessoren, wobei das Verfahren aufweist:

Umwandeln (604) von einer oder mehreren, als eine Mehrzahl von Gleitkomma-Zahlenformaten (300) dargestellten Eingaben in ein Obermengen-Gleitkommaformat vor der Berechnung durch eine oder mehrere vereinfachte Obermengen-Gleitkommaeinheiten, ssFPUs (412);
Durchführen (606) einer Berechnungsoperation auf der einen oder den mehreren, als das Obermengen-Gleitkommaformat dargestellten Eingaben unter Verwenden der einen oder der mehreren ssFPUs;
Identifizieren (804) der Mehrzahl von Gleitkomma-Zahlenformate als ein Format mit sehr niedriger Genauigkeit, VLP, das ein Vorzeichen-Bit (306), Exponenten-Bits (308) und Mantissen-Bits (310) aufweist, wobei es sich bei dem VLP um ein 8-Bit-Gleitkommaformat handelt; und
Identifizieren des Obermengen-Gleitkommaformats als ein Single-Gleitkommaformat, wobei es sich bei dem Obermengen-Gleitkommaformat um ein 9-Bit-Gleitkommaformat handelt, das ein Vorzeichen-Bit, Exponenten-Bits und Mantissen-Bits aufweist, und wobei es sich bei der einen oder den mehreren ssFPUs um eine 9-Bit-Gleitkommaeinheit handelt.

2. Verfahren nach Anspruch 1, das ferner das Umwandeln (806) der einen oder mehreren, als eine Mehrzahl von 8-Bit-Gleitkommaformaten dargestellten Eingaben in das Obermengen-Gleitkommaformat vor der Berechnung durch die eine oder die mehreren ssFPUs enthält.

3. Verfahren nach einem vorangehenden Anspruch, das ferner das Bestimmen enthält, dass es sich bei der Mehrzahl von Gleitkommaformaten um ein Arbeitsspeicher-Speicherformat und bei dem Obermengen-Gleitkommaformat um ein Berechnungsformat handelt.

4. Verfahren nach Anspruch 1, das ferner enthält:

Durchführen (808) des Umwandelns der einen oder der mehreren, als eine Mehrzahl von 8-Bit-Gleitkommaformaten (300) dargestellten Eingaben in das Obermengen-Gleitkommaformat an einem Randbereich der einen oder der mehreren ssFPUs; und
gleichzeitiges Durchführen (616) der Berechnungsoperation auf der einen oder den mehreren, als das Obermengen-Gleitkommaformat dargestellten Eingaben unter Verwenden der einen oder der mehreren ssFPUs.

5. Verfahren nach Anspruch 1, das ferner das Zusammenführen der Mehrzahl von Gleitkomma-Zahlenformaten für das Umwandeln in das Obermengen-Gleitkommaformat enthält, um die Berechnungsoperation zum Erlauben des Maschinenlernen-Trainings mit sehr geringer Genauigkeit in einer Maschinenlernen-Operation durchzuführen.

6. Verfahren nach Anspruch 1, das ferner das Verhindern von Rundungsfehlern vor der Berechnungsoperation durch Auswählen des Obermengen-Gleitkommaformats enthält, um die Mehrzahl von Gleitkomma-Zahlenformaten zu ersetzen.

7. System zum Durchführen von Gleitkommaformat-Berechnungen mit hybrider Genauigkeit über eine vereinfachte Obermengen-Gleitkommaeinheit (412) in einer Datenverarbeitungs-Umgebung (200), wobei das System aufweist: einen oder mehrere Computer mit ausführbaren Anweisungen, die das System beim Ausführen veranlassen zum:

Umwandeln (604) einer oder mehrerer, als eine Mehrzahl von Gleitkomma-Zahlenformaten dargestellten Eingaben in ein Obermengen-Gleitkommaformat vor der Berechnung durch eine oder mehrere vereinfachte Obermengen-Gleitkommaeinheiten, ssFPUs;
Durchführen (606) einer Berechnungsoperation auf der einen oder den mehreren, als das Obermengen-Gleitkommaformat dargestellten Eingaben unter Verwenden der einen oder der mehreren ssFPUs;
Identifizieren der Mehrzahl von Gleitkomma-Zahlenformaten als ein Format mit sehr geringer Genauigkeit, VLP, das ein Vorzeichen-Bit (306), Exponenten-Bits (308) und Mantissen-Bits (310) aufweist, wobei es sich bei dem VLP um ein 8-Bit-Gleitkommaformat handelt; und
Identifizieren des Obermengen-Gleitkommaformats als ein Single-Gleitkommaformat, wobei es sich bei dem Obermengen-Gleitkommaformat um ein 9-Bit-Gleitkommaformat handelt, das ein Vorzeichen-Bit, Exponenten-Bits und Mantissen-Bits aufweist, und wobei es sich bei der einen oder den mehreren ssFPUs um eine 9-Bit-Gleitkommaeinheit handelt.

8. System nach Anspruch 7, wobei die ausführbaren Anweisungen beim Ausführen das System zum Umwandeln der einen oder mehreren, als eine Mehrzahl von 8-Bit-Gleitkommaformaten dargestellten Eingaben in das Obermengen-Gleitkommaformat vor der Berechnung durch die eine oder die mehreren ssFPUs veranlassen.

9. System nach den Ansprüchen 7 oder 8, wobei die ausführbaren Anweisungen beim Ausführen das System zum Bestimmen veranlassen, dass es sich bei der Mehrzahl von Gleitkomma-Zahleneinheiten um ein Arbeitsspeicher-Speicherformat und bei dem Obermengen-Gleitkommaformat um ein Berechnungsformat handelt.

10. System nach Anspruch 7, wobei die ausführbaren Anweisungen beim Ausführen das System veranlassen zum:

Durchführen des Umwandelns der einen oder mehreren, als eine Mehrzahl von 8-Bit-Gleitkommaformaten dargestellten Eingaben in das Obermengen-Gleitkommaformat an einem Randbereich der einen oder der mehreren ssFPUs; und
gleichzeitiges Durchführen der Berechnungsoperation auf der einen oder den mehreren, als das Obermengen-Gleitkommaformat dargestellten Eingaben unter Verwenden der einen oder der mehreren ssFPUs.

11. System nach Anspruch 7, wobei die ausführbaren Anweisungen beim Ausführen das System zum Zusammenführen der Mehrzahl von Gleitkomma-Zahlenformaten für das Umwandeln in das Obermengen-Gleitkommaformat veranlassen, um die Berechnungsoperation zum Erlauben des Maschinenlernen-Trainings in einer Maschinenlernen-Operation mit sehr geringer Genauigkeit durchzuführen.

12. System nach Anspruch 7, wobei die ausführbaren Anweisungen beim Ausführen das System zum Verhindern von Rundungsfehlern vor der Berechnungsoperation durch Auswählen des Obermengen-Gleitkommaformats veranlassen, um die Mehrzahl von Gleitkomma-Zahlenformaten zu ersetzen.

13. Computerprogramm-Produkt zum Durchführen von Gleitkommaformat-Berechnungen mit hybrider Genauigkeit über eine vereinfachte Obermengen-Gleitkommaeinheit, wobei das Computer-Programmprodukt aufweist: ein computerlesbares Speichermedium, das durch eine Verarbeitungsschaltung lesbar ist und das Speichern von Anweisungen zur Ausführung durch die Verarbeitungsschaltung zum Durchführen eines Verfahrens nach einem der Ansprüche 1 bis 6.

14. Computerprogramm, das auf einem computerlesbaren Speichermedium gespeichert ist und in den internen Arbeitsspeicher eines Digitalcomputers ladbar ist, wobei das Computerprogramm Software zum Durchführen des Verfahrens nach einem der Ansprüche 1 bis 6 aufweist, wenn das Programm auf einem Computer ausgeführt wird.

**Revendications**

1. Procédé mis en œuvre par ordinateur pour effectuer des calculs au format de virgule flottante de précision hybride via une unité de virgule flottante de sur-ensemble simplifiée par un ou plusieurs processeurs, comprenant :

   la conversion (604) d'une ou plusieurs entrées, représentées sous la forme d'une pluralité de formats de nombres à virgule flottante (300), en un format de virgule flottante de sur-ensemble avant le calcul par une ou plusieurs unités de virgule flottante de sur-ensemble simplifiées, ssFPUs (412) ;
   l'exécution (606) d'une opération de calcul sur une ou plusieurs entrées représentées par le format de virgule flottante de sur-ensemble en utilisant une ou plusieurs ssFPUs ;
   l'identification (804) de la pluralité de formats de nombres à virgule flottante comme un format de très basse précision, VLP, comprenant un bit de signe (306), des bits d'exposant (308) et des bits de mantisse (310), dans lequel le VLP est un format de virgule flottante de 8 bits ; et
   l'identification du format de virgule flottante de sur-ensemble comme un format de virgule flottante unique, dans lequel le format de virgule flottante de sur-ensemble est un format de virgule flottante de 9 bits comprenant un bit de signe, des bits d'exposant et des bits de mantisse et une ou plusieurs ssFPUs sont une unité de virgule flottante de 9 bits.

2. Procédé selon la revendication 1, comprenant en outre la conversion (806) d'une ou plusieurs entrées, représentées sous la forme d'une pluralité de formats à virgule flottante de 8 bits, au format à virgule flottante de sur-ensemble avant le calcul par une ou plusieurs ssFPUs.

3. Procédé selon une quelconque des revendications précédentes, comprenant en outre la détermination de la pluralité de formats de nombres à virgule flottante comme étant un format de stockage de mémoire et le format à virgule flottante de sur-ensemble est un format de calcul.

4. Procédé selon la revendication 1, comprenant en outre :

   l'exécution de la conversion (808) d'une ou plusieurs entrées, représentées par une pluralité de formats à virgule flottante de 8 bits (300), au format à virgule flottante de sur-ensemble à un bord d'une ou plusieurs ssFPUs ; et
   l'exécution simultanée (616) de l'opération de calcul sur une ou plusieurs entrées représentées par le format à virgule flottante de sur-ensemble en utilisant une ou plusieurs ssFPUs.

5. Procédé selon la revendication 1, comprenant en outre la fusion de la pluralité de formats de nombres à virgule flottante pour la conversion dans le format à virgule flottante de sur-ensemble pour exécuter l'opération de calcul afin de permettre une formation d'apprentissage automatique de très faible précision dans une opération d'apprentissage automatique.

6. Procédé selon la revendication 1, comprenant en outre la prévention des erreurs d'arrondi avant l'opération de calcul en sélectionnant le format de nombre à virgule flottante de sur-ensemble pour remplacer la pluralité de formats de nombre à virgule flottante.

7. Système permettant d'effectuer des calculs au format de virgule flottante de précision hybride via une unité de virgule flottante de sur-ensemble simplifiée (412) dans un environnement informatique (200), comprenant :
   un ou plusieurs ordinateurs dotés d'instructions exécutables qui, lorsqu'elles sont exécutées, amènent le système à :

   convertir (604) une ou plusieurs entrées, représentées sous la forme d'une pluralité de formats de nombres à virgule flottante (300), en un format de virgule flottante de sur-ensemble avant le calcul par une ou plusieurs unités de virgule flottante de sur-ensemble simplifiées, ssFPUs (412) ;

effectuer (606) une opération de calcul sur une ou plusieurs entrées représentées par le format de virgule flottante de sur-ensemble en utilisant une ou plusieurs ssFPUs ;

identifier la pluralité de formats de nombres à virgule flottante comme un format de très basse précision, VLP, comprenant un bit de signe (306), des bits d'exposant (308) et des bits de mantisse (310), dans lequel le VLP est un format de virgule flottante de 8 bits ; et

identifier le format de virgule flottante de sur-ensemble comme un format de virgule flottante unique, dans lequel le format de virgule flottante de sur-ensemble est un format de virgule flottante de 9 bits comprenant un bit de signe, des bits d'exposant et des bits de mantisse et une ou plusieurs ssFPUs sont une unité de virgule flottante de 9 bits.

8. Système selon la revendication 7, dans lequel les instructions exécutables, lorsqu'elles sont exécutées, amènent le système à convertir une ou plusieurs entrées, représentées sous la forme d'une pluralité de formats à virgule flottante de 8 bits, au format à virgule flottante de sur-ensemble avant le calcul par une ou plusieurs ssFPUs.

9. Système selon une quelconque des revendications 7 ou 8, dans lequel les instructions exécutables, lorsqu'elles sont exécutées, amènent le système à déterminer la pluralité de formats de nombres à virgule flottante comme étant un format de stockage de mémoire et le format à virgule flottante de sur-ensemble est un format de calcul.

10. Système selon la revendication 7, dans lequel les instructions exécutables, une fois exécutées, amènent le système à :

effectuer la conversion d'une ou plusieurs entrées, représentées sous la forme d'une pluralité de formats à virgule flottante de 8 bits, au format à virgule à un bord d'une ou plusieurs ssFPUs ; et

effectuer simultanément l'opération de calcul sur une ou plusieurs entrées représentées par le format à virgule flottante de sur-ensemble en utilisant une ou plusieurs ssFPU.

11. Système selon la revendication 7, dans lequel les instructions exécutables, lorsqu'elles sont exécutées, amènent le système à fusionner la pluralité de formats de nombres à virgule flottante pour la conversion au format à virgule flottante de sur-ensemble pour effectuer l'opération de calcul afin de permettre une formation d'apprentissage automatique de très faible précision dans une opération d'apprentissage automatique.

12. Système selon la revendication 7, dans lequel les instructions exécutables, lorsqu'elles sont exécutées, amènent le système à empêcher les erreurs d'arrondi avant l'opération de calcul en sélectionnant le format à virgule flottante de sur-ensemble pour remplacer la pluralité de formats de nombres à virgule flottante.

13. Produit de programme informatique pour effectuer un calcul au format de virgule flottante de précision hybride via une unité de virgule flottante de sur-ensemble simplifiée, le produit de programme informatique comprenant : un support de mémorisation lisible par ordinateur lisible par un circuit de traitement et mémorisant des instructions en vue d'une exécution par le circuit de traitement pour exécuter un procédé selon une quelconque des revendications 1 à 6.

14. Programme informatique mémorisé sur un support lisible par ordinateur et chargeable dans la mémoire interne d'un ordinateur numérique, comprenant un logiciel permettant d'exécuter le procédé selon une quelconque des revendications 1 à 6, lorsque ledit programme est exécuté sur un ordinateur.

FIG. 1

**FIG. 2**

**FIG. 3**

EP 4 211 549 B1

FIG. 4A

450

402

OFF-CHIP MEMORY BANK

FP8    404

MEMORY HIERARCHY

FP8    404A

LOCAL MEMORY BANK

FP8    406A

408

I-DECODE    FP8-TO-FP9 CONVERSION

FP9 | 412A    FP9 | 412B    FP9 | 412C

FP9    ssFPU    ssFPU    ■ ■ ■    ssFPU

412D    412E    412F

FP8    FP8    FP9    ssFPU    ssFPU    ssFPU

LOCAL MEMORY BANK

FP8-TO-FP9 CONVERSION

■
■412G    412H    ■
■
■
■    412I

FP9    ssFPU    ssFPU    ■ ■ ■    ssFPU

404B    406B

CONTROL SIGNAL
DATAPATH FP8
DATAPATH FP9

FIG. 4B

500

$2^{16}$

$2^4$

1/5/2
RANGE
FIXED

1/4/3 RANGE
PROGRAMMABLE
VIA EXPONENT BIAS

$2^{-11}$

$2^{-15}$

NO LOSS OF INFORMATION DURING CONVERSIONS TO FP9 FORMAT

# FIG. 5

600

START

602

CONVERT ONE OR MORE INPUTS, REPRESENTED AS A PLURALITY OF
FLOATING POINT NUMBER FORMATS, INTO A SUPERSET FLOATING
POINT FORMAT PRIOR TO COMPUTATION BY ONE OR MORE
SIMPLIFIED SUPERSET FLOATING POINT UNITS (SSFPU'S)

604

PERFORM A COMPUTE OPERATION ON THE ONE OR MORE
INPUTS, REPRESENTED AS THE SUPERSET FLOATING POINT
FORMAT, USING THE ONE OR MORE SSFPU'S

606

END

608

# FIG. 6

700

START
~702

CONVERT A PLURALITY OF INPUTS, REPRESENTED AS VERY
LOW PRECISION ("VLP") FLOATING POINT FORMATS, INTO
A SUPERSET FLOATING POINT FORMAT
~704

PERFORM A COMPUTE OPERATION ON THE PLURALITY OF INPUTS,
REPRESENTED AS THE SUPERSET FLOATING POINT FORMAT, USING
AN ARRAY OF A PLURALITY OF SIMPLIFIED SUPERSET FLOATING POINT
UNITS (SSFPU'S)
~706

END
~708

**FIG. 7**

800

START
802

IDENTIFY INPUT OPERANDS REPRESENTED AS VERY LOW PRECISION ("VLP") FLOATING POINT FORMATS
804

CONVERT THE INPUT OPERANDS, REPRESENTED AS VLP FLOATING POINT FORMATS, INTO A SUPERSET FLOATING POINT FORMAT TO PREVENT ROUNDING ERRORS PRIOR TO PERFORMING A COMPUTE OPERATION IN AN ARRAY OF SIMPLIFIED SUPERSET FLOATING POINT UNITS (SSFPU'S)
806

PERFORM A COMPUTE OPERATION ON THE INPUT OPERANDS, REPRESENTED AS THE SUPERSET FLOATING POINT FORMAT, USING THE ARRAY OF THE SSFPU'S
808

END
810

# FIG. 8

**EP 4 211 549 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20200249910 A1
- US 5268855 A

**Non-patent literature cited in the description**

- **WANG, N. et al.** *Hybrid Floating Point Representation for Deep Learning Acceleration*, 06 August 2020
- **MASON, R.W. et al.** *Common Format for Encoding Both Single and Double Precision Floating Point Numbers*, 07 December 1993